# EUROPEAN PATENT SPECIFICATION

(11) **EP 3 873 106 B1**
(45) Date of publication and mention of the grant of the patent: **19.03.2025**
(21) Application number: 20188271.9
(22) Date of filing: 29.07.2020
(51) Int. Cl.: H04R 17/00

(54) **VIBRATOR APPARATUS AND ELECTRONIC DEVICE HAVING THE SAME**
VIBRATORVORRICHTUNG UND ELEKTRONISCHE VORRICHTUNG DAMIT
APPAREIL VIBRATEUR ET DISPOSITIF ÉLECTRONIQUE LE COMPRENANT

(30) Priority: 27.02.2020 CN 202010125988
(43) Date of publication of application: 01.09.2021
(73) Proprietor: Beijing Xiaomi Mobile Software Co., Ltd., Beijing 100085 (CN)
(72) Inventor: CHEN, Jing, Beijing, Beijing 100085 (CN); GU, Jianglin, Beijing, Beijing 100085 (CN)
(74) Representative: dompatent von Kreisler Selting Werner - Partnerschaft von Patent- und Rechtsanwälten mbB

(56) References cited:
- US-A1- 2012 140 969
- US-A1- 2015 326 976
- US-A1- 2016 219 362
- US-A1- 2019 297 420

## Description

### TECHNICAL FIELD

The present invention relates to a field of electronic devices, and more particularly an electronic device including a vibrator apparatus.

### BACKGROUND

With the development of science and technology, a holeless electronic device with a full screen has become a mainstream of development, which needs to cancel a structure of a sound output hole arranged on the same face with a display screen, thus promoting the development of sound generation technology. Taking the sound generation technology by a screen as an example, a vibrator is fixed to the display screen and drives the display screen to vibrate to generate sound. In this way, a loudspeaker of the electronic device is replaced and the structure of the sound output hole is cancelled, which is conductive to the full screen of the electronic device and the holeless electronic device. However, a sound pressure level of a frequency response curve of the vibrator is not balanced at low and high frequencies, which is not conducive to ensuring a sound quality of the electronic device.

US2019297420A1 relates to a panel loudspeaker controller for controlling a panel loudspeaker including a plurality of actuators. The panel loudspeaker controller includes: a plurality of electrical signal inputs, each input being associated with each actuator of the panel loudspeaker to be controlled; a plurality of signal processors, each signal processor being associated with each input and having an output for an electrical signal to control an actuator of the panel loudspeaker, and each signal processor implementing a transfer function from its input to its output based on each actuator of the panel loudspeaker to a desired acoustic receiver; and a signal processor controller associated with all of the plurality of signal processors, wherein the signal processor controller is preconfigured to improve phase alignment between the signals as an ensemble output at the outputs of the signal processors. The actuators may consist of two piezoelectric elements or patches of unequal size attached directly to the rear of a display stiffening plate.

US2012140969A1 relates to a piezoelectric speaker which radiates acoustic waves by vibrating according to an applied voltage, including (i) a substrate which includes a first region having first bending stiffness against bending of a plane perpendicular to a vibration direction and a second region having second bending stiffness against bending of the perpendicular plane, the second bending stiffness being different from the first bending stiffness, (ii) a first piezoelectric element which is mounted on the first region and to which a voltage of a first frequency band is applied, and (iii) a second piezoelectric element which is mounted on the second region and to which a voltage of a second frequency band different from the first frequency band is applied. The first region is a bass-range sound reproduction region. Multiple second regions, being smaller than the first region, may be provided around the first region.

US20150326976 relates to an acoustic generator including at least a plurality of piezoelectric elements (exciters) and a vibrating potion. The piezoelectric elements vibrate upon reception of input of an electric signal. The piezoelectric elements are attached to the vibrating portion. The piezoelectric elements are attached to the vibrating portion asymmetrically with respect to all the symmetry axes of a figure drawn by a contour of the vibrating portion when seen from the above. The thickness of at least one of the plurality of exciters is made different from the thickness of the other exciter.

US20160219362 relates to a balanced acoustic device including an enclosure defining an acoustic chamber, a first passive radiator diaphragm having an active driver assembly and a second passive radiator diaphragm having a plurality of active driver assemblies that are laterally offset. The moving mass of the first passive radiator assembly is substantially equal to the moving mass of the second passive radiator diaphragm. The lateral offsets of the active driver assemblies in the second passive radiator diaphragm eliminate their interference within the enclosure with the active driver assembly of the first passive radiator diaphragm. Advantageously, a smaller distance between the two passive radiator diaphragms is allowed and therefore a smaller enclosure is possible.

### SUMMARY

The present invention provides an improved vibrator apparatus and an electronic device.

An aspect of the present invention provides an electronic device. The electronic device includes a vibrator apparatus comprising a body and a plurality of vibrators, wherein the vibrator apparatus is fixed in the body of the electronic device, the plurality of vibrators are separately disposed in the body and configured to vibrate to generate sound. Each of the plurality of vibrators comprises a bonding face configured to be bonded to the body. Two or more vibrators of the plurality of vibrators have at least one of the following different qualities: thicknesses, different areas of the bonding face or different shapes of the bonding face. The thickness of each of the plurality of vibrators is measured along a direction perpendicular to the bonding face.

The plurality of vibrators includes a first vibrator and at least one second vibrator, the first vibrator and the at least one second vibrator are separately disposed, and area of a bonding face of the first vibrator is larger than area of a bonding face of the second vibrator.

Preferably, the at least one second vibrator is disposed closer to an edge or a corner of the body than the first vibrator is.

According to the invention at least two second vibrators are provided, and the at least two second vibrators are disposed symmetrically around a center of gravity of the first vibrator.

The at least two second vibrators are disposed in a circular form.

The thickness of the first vibrator is larger than the thickness of the second vibrator.

Preferably, the plurality of vibrators include a vibrator with a single-layer structure and/or a vibrator with a multi-layer structure.

Optionally, the plurality of vibrators include at least one of a piezoelectric film or a piezoelectric ceramic; and/or, the vibrator apparatus further includes an adhesive layer disposed on the bonding face, and the adhesive layer is configured to connect the bonding face to the body; and/or, the vibrator apparatus further includes a flexible printed circuit board, and the flexible printed circuit board is connected with the plurality of vibrators at a face opposite to the bonding face.

The plurality of vibrators of the vibrator apparatus are bonded to a face of the housing facing the screen display.

Preferably, the electronic device further includes a controller connected with the vibrator apparatus. The controller is configured to control vibration of two or more vibrators of the plurality of vibrators of the vibrator apparatus; and/or the controller is configured to control the plurality of vibrators of the vibrator apparatus to vibrate under at least one driving voltage.

The electronic device provided by the embodiments of the present invention at least have following beneficial effects.

In the electronic device according to the present invention, two or more than two vibrators of the plurality of vibrators have at least one of following different qualities: thicknesses, areas of the bonding face, or shapes of the bonding face. By means of the cooperation of these vibrators, not only the sound pressure level of the frequency response curve of the vibrator apparatus is balanced and consistent, so as to improve the sound generation effect, but also more possibilities for flexible arrangements of the vibrators are provided, which is conducive to reducing the occupied space, such that the electronic device is highly integrated and the volume of the electronic device is miniaturized. Moreover, compared with a plurality of identical vibrators, the thickness, the area of the bonding face, the shape of the bonding face and/or the number of the vibrators in the present invention can be flexibly designed, which is conducive to reducing the power consumption. The adoption of the vibrator apparatus also facilitates the development of the full screen of the electronic device and the holeless electronic device.

It should be understood that the above general description and the detailed description below are merely used to explain the present invention, and cannot be construed as a limitation to the present invention.

### BRIEF DESCRIPTION OF THE DRAWINGS

The accompanying drawings, which are incorporated in and constitute a part of this specification, illustrate examples consistent with the present invention and, together with the description, serve to explain the principles of the present invention. It is to be noted that -contrary to the claimed embodiment- some of the following figures for example show the vibrators as being attached to the screen display rather than to a face of the housing facing the screen display. Also, not all depicted first and second vibrators have different thickness. Therefore, the following detailed description illustrates partial aspects of the invention, but the scope of the invention is solely defined by the appended claims.
Fig. 1 illustrates a schematic view of a partial structure of an electronic device according to an illustrative example of the present invention.
Fig. 2 illustrates a schematic view of a partial structure of an electronic device according to an illustrative example of the present invention.
Fig. 3 illustrates an enlarged schematic view of the partial structure of the electronic device in Fig. 1.
Fig. 4 illustrates a schematic view of frequency response curves of three vibrators with different areas of bonding faces according to an illustrative example of the present invention.
Fig. 5 illustrates a schematic view of frequency response curves of three vibrators arranged at different positions according to an illustrative example of the present invention.
Fig. 6 illustrates a schematic view of an arrangement of a vibrator apparatus according to an illustrative example of the present invention.
Fig. 7 illustrates a schematic view of an arrangement of a vibrator apparatus according to an illustrative example of the present invention.
Fig. 8 illustrates a schematic view of an arrangement of a vibrator apparatus according to an illustrative example of the present invention.
Fig. 9 illustrates a schematic view of an arrangement of a vibrator apparatus according to an illustrative example of the present invention.
Fig. 10 illustrates a schematic view of frequency response curves of three vibrators with different thicknesses according to an illustrative example of the present invention.

### DETAILED DESCRIPTION

Reference will now be made in detail to illustrative examples with the accompanying drawings. The following description refers to the accompanying drawings in which the same numbers in different drawings represent the same or similar elements unless otherwise represented. The implementations set forth in the following description of illustrative examples do not represent all implementations consistent with the present invention. Instead, they are merely examples of apparatuses and methods consistent with aspects related to the present invention as recited in the appended claims.

The terms used in the present invention are merely for the purpose of describing specific examples, which are not intended to limit the present invention. Unless defined otherwise, the technical or scientific terminologies used in the present invention shall be the general meaning understood by those skilled in the related art of the present invention. Terms such as "first", "second" or the like used in the descriptions and claims of the present invention do not indicate any order, quantity or importance, but are only used to distinguish different components. Similarly, terms such as "one" or "a" do not refer to quantity limitation, but indicate the existence of at least one. Unless specified otherwise, terms such as "comprise", "include" or the like mean that the elements or objects presented before "comprise" or "include" contain the elements or objects and their equivalents presented after "comprise" or "include", while other elements or objects are not excluded. The terms "interconnect", "connected" or the like are not restricted to physical or mechanical connections, but may also be electrical connections, no matter direct or indirect.

As used in the descriptions and the appended claims of the present invention, "a" and "the" in singular forms mean including plural forms, unless clearly indicated in the context otherwise. It should also be understood that, as used herein, the term "and/or" represents and contains any and all possible combinations of one or more associated listed items.

In some examples, an electronic device includes a body and a vibrator arranged in the body, and the vibrator is configured to vibrate to generate sound. However, a frequency response curve of the vibrator does not have a balanced sound pressure level at low and high frequencies, which cannot ensure a sound quality and is not conducive to replacing a loudspeaker of the electronic device.

In other examples, an electronic device includes a body and a vibrator apparatus arranged in the body. The vibrator apparatus includes a plurality of identical vibrators in a regular and orderly arrangement. Although the sound pressure level of the frequency response curve of the vibrator apparatus is relatively balanced, so as to solve a problem of the unbalanced sound pressure level in low, medium and high frequencies, the limitation is relatively great. The limitation includes that an arrangement of the plurality of vibrators is not flexible and occupies a large area, and the dimension and number of the plurality of vibrators cannot be designed flexibly, which is not conducive to reducing the power consumption.

In order to solve the above problems, the present invention provides a vibrator apparatus and an electronic device, and the vibrator apparatus is fixed in a body of the electronic device. The vibrator apparatus includes at least two vibrators separately disposed in the body, and configured vibrate to generate sound. The vibrator includes a bonding face configured to be bonded to the body. Two or more than two vibrators of the at least two vibrators have at least one of different thicknesses, different areas of the bonding faces and different shapes of the bonding faces. The thickness of the vibrator is a dimension of the vibrator along a direction perpendicular to the bonding face. The electronic device includes the body and the vibrator apparatus fixed in the body.

In the vibrator apparatus and the electronic device according to the present invention, the two or more than two vibrators of the at least two vibrators have at least one of following different qualities: thicknesses, areas of the bonding face, or shapes of the bonding face. By means of the cooperation of these vibrators, not only the sound pressure level of the frequency response curve of the vibrator apparatus is balanced and consistent, so as to improve the sound generation effect, but also more possibilities for flexible arrangements of the vibrators are provided, which is conducive to reducing the occupied space, such that the electronic device is highly integrated and the volume of the electronic device is miniaturized. Moreover, compared with a plurality of identical vibrators, the thickness, the area of the bonding face, the shape of the bonding face and/or the number of the vibrators in the examples of the present invention can be flexibly designed, which is conducive to reducing the power consumption. The adoption of the vibrator apparatus also facilitates the development of the full screen of the electronic device and the holeless electronic device.

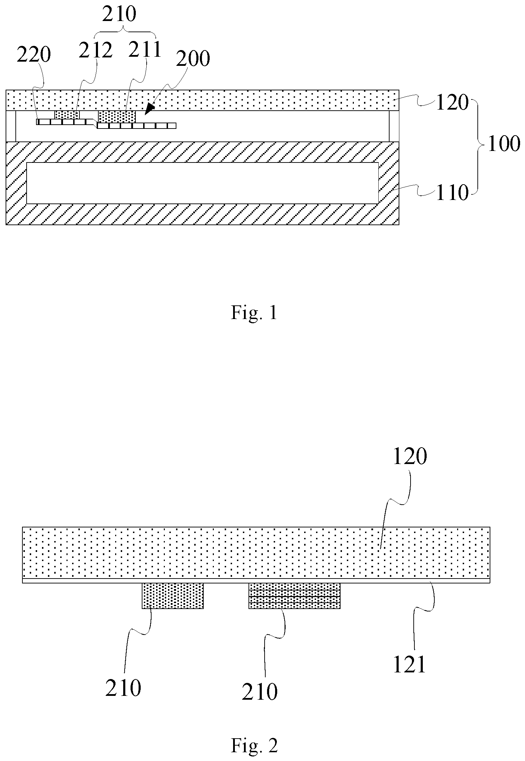

In order to understand the vibrator apparatus and the electronic device provided in the present invention more clearly, following detailed descriptions are made with reference to Figs. 1-10.

The electronic device provided in the examples of the present invention includes, but is not limited to, a mobile phone, a tablet computer, an iPad, a digital broadcasting terminal, a message receiving and sending device, a game console, a medical facility, a fitness facility, a personal digital assistant, and other intelligent devices, etc.

Fig. 1 illustrates a partial schematic view of an electronic device according to an illustrative example of the present invention. The electronic device includes a body 100, a vibrator apparatus 200 and a controller, and the vibrator apparatus 200 is fixed in the body 100. The vibrator apparatus 200 may drive at least part of the body 100 to vibrate to generate sound, so as to replace a loudspeaker or other sound generators of the electronic device, which is conducive to cancelling a sound output hole of the electronic device and promoting the design of the full screen of the electronic device and the holeless electronic device.

In some examples, the body 100 includes a housing 110, and the vibrator apparatus 200 is fixed in the housing 110.

In other examples, as illustrated in Fig. 1, the body 100 includes a housing 110 and a screen display 120 arranged on a front face of the housing 110, a space is formed between the housing 110 and the screen display 120, and the vibrator apparatus 200 is arranged in the space. In some examples, a vibrator 210 of the vibrator apparatus 200 is bonded to a face of the housing 110 facing the screen display 120, and the vibrator apparatus 200 drives the housing 110 to vibrate to generate sound. The housing 110 may include a middle frame, and the vibrator apparatus 200 is fixed to the middle frame.

In other examples, the vibrator 210 of the vibrator apparatus 200 is bonded to a face of the screen display 120 facing the housing 110, and the vibrator apparatus 200 drives the screen display 120 to vibrate to generate sound. Further, when the vibrator 210 is bonded to the screen display 120, a gap may be formed between the vibrator apparatus 200 and the housing 110 to avoid driving the housing 110 to vibrate, thus ensuring the user's comfortable experience of holding the electronic device.

Fig. 2 illustrates a partial schematic view of an electronic device according to an illustrative example of the present invention. In some examples, as illustrated in Fig. 2, the face of the display screen 120 facing the housing 110 is provided with a shielding layer 121, and the vibrator 210 of the vibrator apparatus 200 is bonded to a face of the shielding layer 121 facing away from the display screen 120. In this way, the vibrator 210 can be avoided from being directly bonded to the display screen 120 to produce a bonding mark, which otherwise affects the display effect of the display screen 120. In some examples, the shielding layer 121 may be bonded to the display screen 120 through a solid adhesive, a liquid adhesive, a UV adhesive, a pressure-sensitive adhesive or the like with a relatively dark color.

The vibrator apparatus 200 includes at least two vibrators 210 separately disposed in the body 100 and a flexible printed circuit board 220.

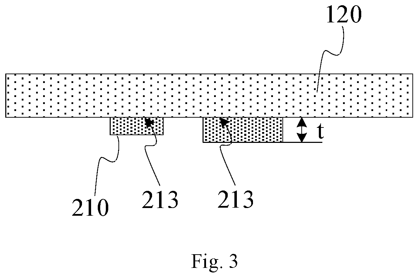

Fig. 3 illustrates a partially enlarged schematic view of the electronic device in Fig. 1. The at least two vibrators 210 are configured to vibrate to generate sound. As illustrated in Fig. 3, the vibrator 210 includes a bonding face 213 configured be bonded to the display screen 120. Two or more than two vibrators 210 of the at least two vibrators 210 have at least one of different thicknesses, different areas of the bonding faces 213, or different shapes of the bonding faces 213. A thickness t of the vibrator 210 is a dimension of the vibrator 210 along a direction perpendicular to the bonding face 213.

It should be noted that, the thicknesses of the two or more than two vibrators 210 of the at least two vibrators 210 are different, or the areas of the bonding faces 213 of the two or more than two vibrators 210 of the at least two vibrators 210 are different, or the shapes of the bonding faces 213 of the two or more than two vibrators 210 of the at least two vibrators 210 are different, or both the thicknesses of the two or more than two vibrators 210 of the at least two vibrators 210 and the areas of the bonding faces 213 of the two or more than two vibrators 210 of the at least two vibrators 210 are different (for instance, the thickness and the area of bonding face 213 of one vibrator 210 are different from the thickness and the area of bonding face 213 of another vibrator 210), or both the thicknesses of the two or more than two vibrators 210 of the at least two vibrators 210 and the shapes of the bonding faces 213 of the two or more than two vibrators 210 of the at least two vibrators 210 are different (for instance, the thickness and the shape of the bonding face 213 of one vibrator 210 are different from the thickness and the shape of the bonding face 213 of another vibrator 210), or both the areas of the bonding faces 213 of the two or more than two vibrators 210 of the at least two vibrators 210 and the shapes of the bonding faces 213 of the two or more than two vibrators 210 of the at least two vibrators 210 are different (for instance, the area and the shape of the bonding face 213 of one vibrator 210 are different from the area and the shape of the bonding face 213 of another vibrator 210), or the thicknesses, the areas of the bonding faces 213 and the shapes of the bonding faces 213 of the two or more than two vibrators 210 of the at least two vibrators 210 are different. Further, some vibrators 210 of the at least two vibrators 210 may have identical thicknesses, identical areas of the bonding faces 213, and/or identical shapes of the bonding faces 213.

In the vibrator apparatus 200 and the electronic device according to the example of the present invention, the two or more than two vibrators 210 of the at least two vibrators 210 have at least one of the different thicknesses, the different areas of the bonding faces 213 and the different shapes of the bonding faces 213, such that the vibrator apparatus 200 includes the vibrator 210 having the frequency response curve with an excellent low frequency performance, the vibrator 210 having the frequency response curve with an excellent intermediate frequency performance and the vibrator 210 having the frequency response curve with an excellent high frequency performance. By means of the cooperation of these vibrators 210, not only the sound pressure level of the frequency response curve of the vibrator apparatus 200 is balanced and consistent, so as to improve the sound generation effect of the electronic device, but also more possibilities for flexible arrangements of the vibrator apparatus 200 are provided, which is conducive to reducing the occupied space, such that the electronic device is highly integrated and the volume of the electronic device is miniaturized. Moreover, compared with a plurality of identical vibrators 210, the thickness, the area of the bonding face 213, the shape of the bonding face 213 and/or the number of the vibrators 210 in the examples of the present invention can be flexibly designed, which is conducive to reducing the power consumption. The adoption of the vibrator apparatus 200 also facilitates the development of the full screen of the electronic device and the holeless electronic device.

In some examples, the at least two vibrators 210 include at least one of a piezoelectric film and a piezoelectric ceramic. In some examples, the at least two vibrators 210 are the piezoelectric films. In some examples, the at least two vibrators 210 are the piezoelectric ceramics. In some examples, the at least two vibrators 210 include the piezoelectric film and the piezoelectric ceramic. Further, the vibrator 210 may be other exciters, which are not specifically limited in the present invention. In some examples, the piezoelectric film is light in weight, soft, and can be easily applied to different spaces within the body 100. Compared with other exciters, the piezoelectric film and the piezoelectric ceramic are more conducive to saving the occupied space.

In some examples, a material of the vibrator 210 includes a piezoelectric material. In some examples, the piezoelectric material includes lead zirconate titanate piezoelectric ceramics (PZT), and polyvinylidene fluoride (PVDF).

The flexible printed circuit board (FPCB) 220 is connected with a face of the vibrator 210 which faces away from the bonding face 213. In some examples, the FPCB 220 is also connected with a controller in the electronic device, and the controller controls the vibrator 210 to operate through the FPCB 220. Moreover, the FPCB 220 may be fitted with spaces of different structures in the body 100, which is conducive to the high integration and the miniaturized volume of the electronic device.

In some examples, the vibrator apparatus 200 also includes an adhesive layer arranged on the bonding face 213, and the adhesive layer is configured to bond the bonding face 213 to the body 100. In some examples, the way that the vibrator 210 is adhered to the body 100 through the adhesive layer is simple and facilitates the production and manufacture of the electronic device. Further, the vibrator 210 may also be fixed to the body 100 in other ways. In some examples, the adhesive layer is formed by a solid adhesive, a liquid adhesive, a UV adhesive, or a pressure-sensitive adhesive.

The controller is connected with the vibrator apparatus 200. Two or more than two vibrators 210 of the at least two vibrators 210 of the vibrator apparatus 200 are controlled to vibrate by the controller, and/or the controller controls the vibrator 210 of the vibrator apparatus 200 to vibrate under at least one driving voltage. In some examples, the controller may control a part of the vibrators 210 to vibrate and other vibrators 210 not to work, and may also control all the vibrators 210 to vibrate. The controller may control the vibrator 210 to vibrate under one driving voltage, and may also control the vibrator 210 to vibrate under a plurality of driving voltages. In this way, it is flexible to control a part of the vibrators 210 to vibrate and adjust the driving voltage based on actual situations, which is not only conductive to the balanced and consistent performance of the frequency response curve of the vibrator apparatus 200, but also conducive to energy saving and consumption reduction.

In some examples, the controller includes an integrated circuit (IC), a plurality of vibrators 210 are connected to the IC in parallel, and the IC may control different vibrators 210 to vibrate with different driving voltages or with identical driving voltage. The plurality of vibrators 210 may also be connected to the IC in series. In other examples, the controller includes a plurality of ICs, and the plurality of ICs are connected to a plurality of vibrators 210 in one to one correspondence. Each IC may control the vibrator 210 connected thereto with a determined driving voltage, and the driving voltages of the plurality of ICs may be identical or different.

In some examples, the vibrator 210 is connected to the IC through at least two metal conductive contacts. When the vibrator apparatus 200 includes the flexible printed circuit board 220, the controller is connected to the vibrator 210 through the flexible printed circuit board 220.

The influences of the area of the bonding face 213, the thickness and the position of the vibrator 210 on the frequency response curve are respectively explained as follows with reference to the drawings.

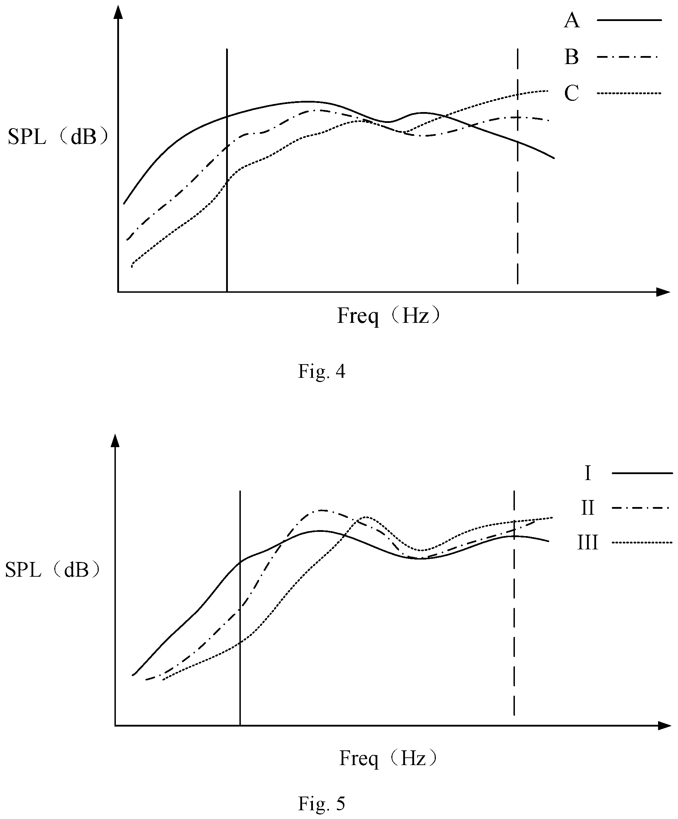

Fig. 4 illustrates a schematic view of frequency response curves of three vibrators 210 having the different areas of the bonding faces 213 according to an illustrative example of the present invention. In Fig. 4, a horizontal axis (Freq) represents a frequency, and the frequency increases gradually along a direction to which an arrow of the horizontal axis points. A longitudinal axis (SPL) represents a sound pressure level, and the sound pressure level increases gradually along a direction to which an arrow of the longitudinal axis points. A frequency corresponding to a solid straight line is less than a frequency corresponding to a dotted straight line. Three frequency response curves A, B, C are the frequency response curves of Vibrator 1, Vibrator 2, and Vibrator 3, respectively. Vibrator 1, Vibrator 2, and Vibrator 3 have the same structure and thickness, but the area of the bonding face of Vibrator 1 >the area of the bonding face of Vibrator 2>the area of the bonding face of Vibrator 3. It can be known from Fig. 4 that, at the solid straight line (i.e. at a relatively low frequency), the sound pressure level of the frequency response curve A >the sound pressure level of the frequency response curve B>the sound pressure level of the frequency response curve C. With the increase of the frequency, the sound pressure level of the frequency response curve A decreases, the sound pressure level of the frequency response curve B and the sound pressure level of the frequency response curve C first decrease and then increase, and the increase amplitude of the sound pressure level of the frequency response curve C is relatively large. At the dotted straight line (i.e. at a relatively high frequency), the sound pressure level of the frequency response curve A<the sound pressure level of the frequency response curve B<the sound pressure level of the frequency response curve C. As can be seen, the larger the area of the bonding face 213 of the vibrator 210 is, the better the low frequency performance of the frequency response curve is, and the smaller the area of the bonding face 213 of the vibrator 210 is, the better the high frequency performance of the frequency response curve is.

In some examples, the at least two vibrators 210 include a first vibrator 211 and at least one second vibrator 212, and the first vibrator 211 and the at least one second vibrator 212 are dispersedly arranged. The area of the bonding face 213 of the first vibrator 211 is larger than that of the second vibrator 212. In some examples, according to the influence of the area of the bonding face 213 on the frequency response curve, the low frequency performance of the frequency response curve of the first vibrator 211 is better than the low frequency performance of the frequency response curve of the second vibrator 211, and the high frequency performance of the frequency response curve of the second vibrator 212 is better than the high frequency performance of the frequency response curve of the first vibrator 211. By means of the cooperation of the first vibrator 211 and the second vibrator 212, it is conductive to the balanced and consistent sound pressure level of the frequency response curve of the vibrator apparatus 200.

In addition, in the example of the present invention, the areas of the bonding faces 213 of all the second vibrators 212 are identical or different, which needs to be designed according to actual situations and is not specifically limited in the present invention.

Fig. 5 illustrates a schematic view of frequency response curves of three vibrators 210 arranged at different positions according to an illustrative example of the present invention. In Fig. 5, a horizontal axis (Freq) represents a frequency, and the frequency increases gradually along a direction to which an arrow of the horizontal axis points. A longitudinal axis (SPL) represents a sound pressure level, and the sound pressure level increases gradually along a direction to which an arrow of the longitudinal axis points. A frequency corresponding to a solid straight line is less than a frequency corresponding to a dotted straight line. Three frequency response curves I, II, III are the frequency response curves of Vibrator 4, Vibrator 5, and Vibrator 6, respectively. Vibrator 4, Vibrator 5, and Vibrator 6 have the same structure and dimension, while the Vibrator 4 is arranged in middle of the body 100, Vibrator 5 is arranged at an edge of the body 100, and Vibrator 6 is arranged at a corner of the body 100. As illustrated in Fig. 5, at the solid straight line (i.e. at a relatively low frequency), the sound pressure level of the frequency response curve I>the sound pressure level of the frequency response curve II>the sound pressure level of the frequency response curve III. With the increase of the frequency, the sound pressure levels of the frequency response curves I, II, III first decrease and then increase. At the dotted straight line (i.e. at a relatively high frequency), the sound pressure level of the frequency response curve I<the sound pressure level of the frequency response curve II<the sound pressure level of the frequency response curve III. As can be seen, the closer the vibrator 210 is to the middle of the body 100, the better the low frequency performance of the frequency response curve is, and the closer the vibrator 210 is to the edge or the corner of the body 100, the better the high frequency performance of the frequency response curve is.

In some examples, the second vibrator 212 is arranged closer to the edge or the corner of the body 100 than the first vibrator 211. In some examples, according to the influence of the arrangement position of the vibrator 210 on the frequency response curve, the low frequency performance of the frequency response curve of the first vibrator 211 is better than the low frequency performance of the frequency response curve of the second vibrator 212, and the high frequency performance of the frequency response curve of the second vibrator 212 is better than the high frequency performance of the frequency response curve of the first vibrator 211. Moreover, the area of the bonding face 213 of the first vibrator 211 is larger than the area of the bonding face 213 of the second vibrator 212, such that the first vibrator 211 takes full advantages of its low frequency performance and the second vibrator 212 takes full advantages of its high frequency performance, which is conductive to that the vibrator apparatus 200 has the balanced and consistent frequency response curve.

In some examples, at least two second vibrators 212 are provided, and the at least two second vibrators 212 are arranged to be centered at a center of gravity of the first vibrator 211. In some examples, the at least two second vibrators 212 are arranged based on the center of gravity of the first vibrator 211, which is conductive to the effective cooperation between the first vibrator 211 and the second vibrator 212 so as to form the balanced and consistent frequency response curve.

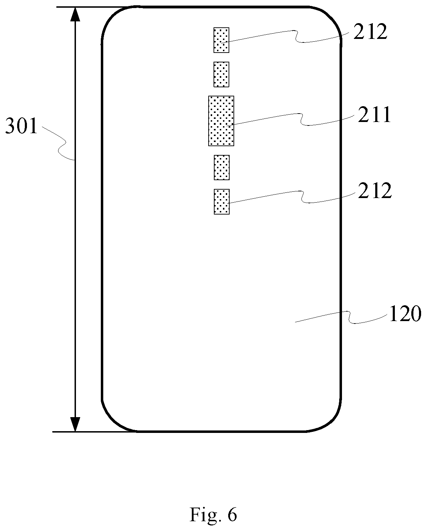

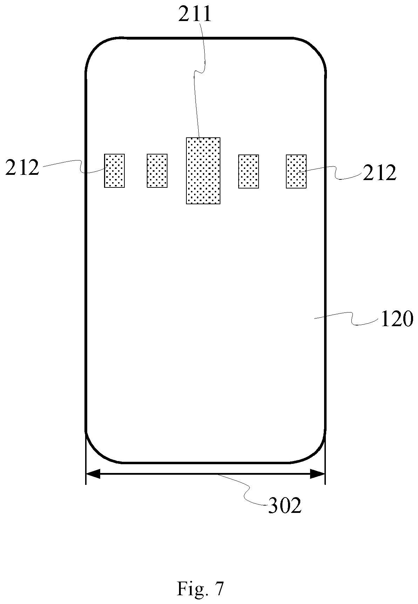

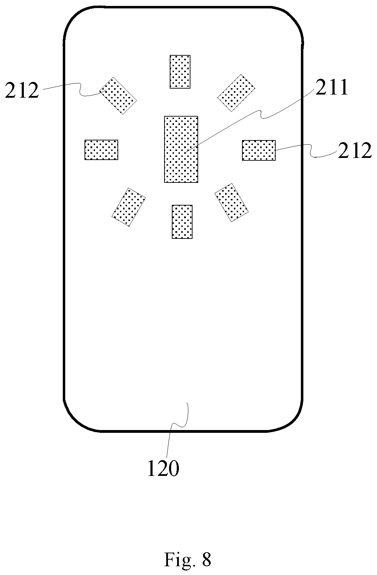

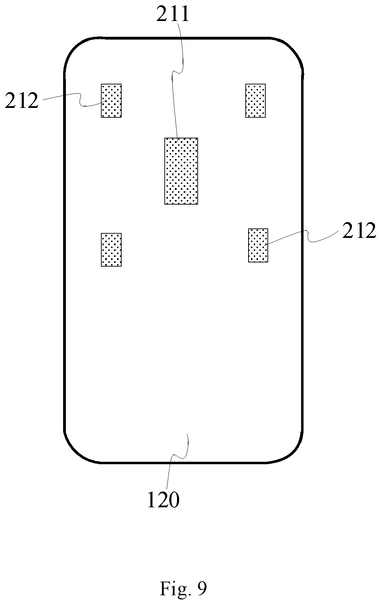

Fig. 6 illustrates a schematic view of an arrangement of the vibrator apparatus 200 according to an illustrative example of the present invention. Fig. 7 illustrates a schematic view of an arrangement of the vibrator apparatus 200 according to an illustrative example of the present invention. Fig. 8 illustrates a schematic view of an arrangement of the vibrator apparatus 200 according to an illustrative example of the present invention. Fig. 9 illustrates a schematic view of an arrangement of the vibrator apparatus 200 according to an illustrative example of the present invention. The present invention gives following examples for the arrangement of the vibrator apparatus 200 with reference to Figs. 6 to 9.

In some examples, the at least two second vibrators 212 are arranged in one of a straight line form (as illustrated in Figs. 6 or 7), a circular form (as illustrated in Fig. 8), or a polygonal form (as illustrated in Fig. 9).

Based on the requirements for the frequency response curve, the occupied space and the power consumption of the vibrator apparatus 200, the at least two second vibrators 212 may be arranged in one or more straight lines. In some examples, as illustrated in Fig. 6, the at least two second vibrators 212 are arranged on both sides of the first vibrator 211 in the straight line form along a length direction 301 of the body 100. In this way, the sound generated from the vibrator apparatus 200 has good directivity along the length direction 301, and thus a sound output hole in this direction can be replaced. Additionally, this arrangement is simple and is conductive to improving the production efficiency of the electronic device.

In other examples, as illustrated in Fig. 7, the at least two second vibrators 212 are arranged on both sides of the first vibrator 211 in the straight line form along a width direction 302 of the body 100. In this way, the sound generated from the vibrator apparatus 200 has good directivity along the width direction 302, and thus a sound output hole in this direction can be replaced. Additionally, this arrangement is simple and is conductive to improving the production efficiency of the electronic device.

In addition, a plurality of second vibrators 212 may be arranged around the first vibrator 211 in a form of a plurality of concentric circles. The plurality of second vibrators 212 may also be arranged around the first vibrator 211 in a form of a plurality of concentric polygons. Arrangement directions of the plurality of second vibrators 212 may be consistent, or may be staggered to form a structure similar to a flower.

In addition, the at least two second vibrators 212 and the first vibrator 211 may also be arranged in other regular or irregular forms.

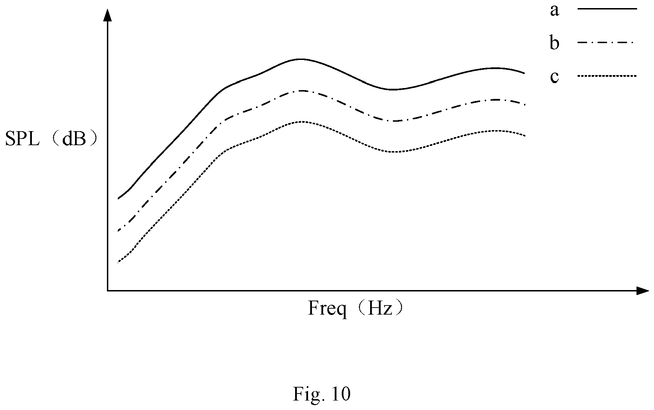

Fig. 10 illustrates a schematic view of frequency response curves of three vibrators 210 with different thicknesses according to an illustrative example of the present invention. In Fig. 10, a horizontal axis (Freq) represents a frequency, and the frequency increases gradually along a direction to which an arrow of the horizontal axis points. A longitudinal axis (SPL) represents the sound pressure level, and the sound pressure level increases gradually along a direction to which an arrow of the longitudinal axis points. Three frequency response curves a, b, c are the frequency response curves of Vibrator 7, Vibrator 8, and Vibrator 9, respectively. Vibrator 7, Vibrator 8 and Vibrator 9 have the same structure and the same area of the bonding face 213, while the thickness of Vibrator 7>the thickness of Vibrator 8 >the thickness of Vibrator 9. It can be seen from Fig. 10 that, the sound pressure level of the frequency response curve a>the sound pressure level of the frequency response curve b>the sound pressure level of the frequency response curve c, and shapes of the frequency response curves a, b, c are identical. As can be seen, the larger the thickness of the vibrator 210 is, the larger the sound pressure level of the frequency response curve is, and the smaller the thickness of the vibrator 210 is, the smaller the sound pressure level of the frequency response curve is.

In some examples, the thickness of the first vibrator 211 is larger than the thickness of the second vibrator 212. In some examples, according to the influence of the thickness on the frequency response curve, by configuring the thickness of the first vibrator 211 to be larger than the thickness of the second vibrator 212, the sound pressure level of the frequency response curve of the first vibrator 211 is improved. The cooperation between the first vibrator 211 and the second vibrator 212 makes the sound pressure level of the frequency response curve balanced and consistent, such that the electronic device has a good sound quality. Moreover, the space at the edge or the corner of the body 100 is usually small, which is conductive to the cooperation between the first vibrator 211 and the second vibrator 212 to effectively occupy the space in the body 100. The thicknesses of the first vibrator 211 and the second vibrator 212 needs to be set according to the internal space of the body 100, the power consumption and the frequency response curve of the vibrator apparatus 200, which is not specifically limited in the present invention.

In some examples, the bonding face 213 of the vibrator 210 has a long strip shape. Compared with a square of the same area, the frequency response curve of the vibrator 210 whose bonding face 213 has the long strip shape has a better performance.

In some examples, further as illustrated in Fig. 2, the at least two vibrators 210 include the vibrator 210 with a single-layer structure and/or the vibrator 210 with a multi-layer structure. In some examples, for the vibrators 210 with the same thickness, the more the layers of the vibrator 210 are, the better the performance of the frequency response curve of the vibrator 210 is. By means of the at least two vibrators 210 including the vibrator 210 with the single-layer structure and/or the vibrator 210 with the multi-layer structure, in conjunction with other factors such as the thickness, the area and the shape of the bonding face 213 or the like, it is further conductive to the balanced and consistent performance of the frequency response curve of the vibrator apparatus 200.

In some examples, the smaller the volume of the vibrator 210 is, the less the power consumption of the vibrator 210 is. That is, the smaller the area of the bonding face 213 and/or the thickness is, the less the power consumption of the vibrator 210 is. Since the at least two vibrators 210 have at least one of the different thicknesses and the different areas of the bonding faces 213, the volumes of the at least two vibrators 210 are different, which provides more possibilities for flexible arrangements. Compared with a plurality of identical vibrators 210, the vibrator apparatus 200 provided in the present invention can flexibly adjust the thickness of the vibrator 210, the area of the bonding face 213 and the number of the vibrators 210, which is conducive to reducing the power consumption.

To sum up, when the vibrator apparatus 200 is applied, at least one of the area and shape of the bonding face 213, the thickness, the position, the number, and the structure layer number of the vibrator 210 can be flexibly adjusted in conjunction with the internal space of the body 100 of the electronic device, such that the vibrator apparatus 200 satisfies requirements of the balanced and consistent frequency response curve, the small occupied space, and the little power consumption, or the like, thus achieving the purposes of being used flexibly, saving the space, and saving the power consumption, which is conductive to the high integration, the miniaturized volume, the full screen of the electronic device and the holeless electronic device.

The above examples of the present invention may be complementary for each other under the case of no conflict.

## Claims

1. An electronic device, comprising:
a body (100); and
a vibrator apparatus (200) comprising:
a plurality of vibrators (210), wherein the vibrator apparatus (200) is fixed in the body (100) of the electronic device, the plurality of vibrators (210) are separately disposed in the body (100) and configured to vibrate to generate sound, and each of the plurality of vibrators (210) comprises a bonding face (213) configured to be bonded to the body (100),
wherein two or more vibrators of the plurality of vibrators (210) have at least one of following different qualities: thicknesses, areas of the bonding face (213), or shapes of the bonding face (213),
wherein the plurality of vibrators (210) comprises a first vibrator (211) and at least two second vibrators (212), the first vibrator (211) and the at least two second vibrators (212) are separately disposed, and an area of a bonding face (213) of the first vibrator (211) is larger than an area of a bonding face (213) of at least one amongst the at least two second vibrators (212),
wherein a thickness of the first vibrator (211) is larger than a thickness of at least one amongst the at least two second vibrators (212), the thickness of each of the plurality of vibrators (210) being measured along a direction perpendicular to the bonding face (213),
wherein the body (100) comprises a housing (110), a screen display (120) disposed on a front face of the housing (110), and a space between the housing (110) and the screen display (120), wherein the vibrator apparatus (200) is mounted in the space,
wherein the at least two second vibrators (212) are disposed symmetrically around a center of gravity of the first vibrator (211),
wherein the at least two second vibrators (212) are disposed in a circular form, and
wherein the plurality of vibrators (210) of the vibrator apparatus (200) are bonded to a face of the housing (110) facing the screen display (120) and configured to drive the housing (110) to vibrate to generate sound.

2. The electronic device according to claim 1, wherein the at least two second vibrators (212) are disposed closer to an edge or a corner of the body (100) than the first vibrator (211) is.

3. The electronic device according to any one of claims 1-2, wherein the plurality of vibrators (210) comprise a vibrator with a single-layer structure and/or a vibrator with a multi-layer structure.

4. The electronic device according to any one of claims 1-3, wherein the plurality of vibrators (210) comprise at least one of a piezoelectric film or a piezoelectric ceramic; and/or,
the vibrator apparatus (200) further comprises an adhesive layer disposed on the bonding face (213), and the adhesive layer is configured to connect the bonding face (213) to the body (100); and/or,
the vibrator apparatus (200) further comprises a flexible printed circuit board (220), and the flexible printed circuit board (220) is connected with the plurality of vibrators (210) at a face opposite to the bonding face (213).

5. The electronic device according to any one of claims 1-4, further comprising a controller connected with the vibrator apparatus (200),
wherein the controller is configured to control vibration of two or more vibrators of the plurality of vibrators (210) of the vibrator apparatus (200); and/or
the controller is configured to control the plurality of vibrators (210) of the vibrator apparatus (200) to vibrate under at least one driving voltage.

## Patentansprüche

1. Elektronische Vorrichtung mit:
einem Körper (100); und
einer Vibratorvorrichtung (200) mit:
mehreren Vibratoren (210), wobei die Vibratorvorrichtung (200) in dem Körper (100) der elektronischen Vorrichtung befestigt ist, die mehreren Vibratoren (210) separat in dem Körper (100) angeordnet sind und dazu ausgebildet sind, zur Erzeugung von Ton zu vibrieren, und jeder der mehreren Vibratoren (210) eine Verklebungsfläche (213) aufweist, die zum Verkleben mit dem Körper (100) ausgebildet ist,
wobei zwei oder mehr Vibratoren der mehreren Vibratoren (210) mindestens eine der folgenden unterschiedlichen Eigenschaften aufweisen: Dicken, Flächen der Verklebungsfläche (213), oder Formen der Verklebungsfläche (213),
wobei die mehreren Vibratoren (210) einen ersten Vibrator (211) und mindestens zwei zweite Vibratoren (212) aufweisen, der erste Vibrator (211) und die mindestens zwei zweiten Vibratoren (212) separat angeordnet sind, und eine Fläche einer Verklebungsfläche (213) des ersten Vibrators (211) größer als eine Fläche einer Verklebungsfläche (213) mindestens einer der mindestens zwei zweiten Vibratoren (212) ist,
wobei eine Dicke des ersten Vibrators (211) größer als eine Dicke mindestens eines der mindestens zwei zweiten Vibratoren (212) ist, wobei die Dicke jedes der mehreren Vibratoren (210) entlang einer zu der Verklebungsfläche (213) senkrechten Richtung gemessen wird,
wobei der Körper (100) ein Gehäuse (110), einen auf einer Vorderseite des Gehäuses (110) angeordneten Anzeigebildschirm (120), und einen Raum zwischen dem Gehäuse (110) und dem Anzeigebildschirm (120) aufweist, wobei die Vibratorvorrichtung (200) in dem Raum angebracht ist,
wobei die mindestens zwei zweiten Vibratoren (212) symmetrisch um einen Schwerpunkt des ersten Vibrators (211) angeordnet sind,
wobei die mindestens zwei zweiten Vibratoren (212) in Kreisform angeordnet sind, und
wobei die mehreren Vibratoren (210) der Vibratorvorrichtung (200) mit einer Fläche des Gehäuses (100) verklebt sind, welche dem Anzeigebildschirm (120) zugewandt ist, und dazu ausgebildet sind, das Gehäuse zum Vibrieren anzutreiben, um Ton zu erzeugen.

2. Elektronische Vorrichtung nach Anspruch 1, bei welcher die mindestens zwei zweiten Vibratoren (212) näher an einem Rand oder einer Ecke des Körpers (100) angeordnet sind als der erste Vibrator (211).

3. Elektronische Vorrichtung nach einem der Ansprüche 1-2, bei welcher die mehreren Vibratoren (210) einen Vibrator mit einer einschichtigen Struktur und/oder einen Vibrator mit einer mehrschichtigen Struktur aufweisen.

4. Elektronische Vorrichtung nach einem der Ansprüche 1-3, bei welcher die mehreren Vibratoren (210) eine piezoelektrische Folie und/oder eine piezoelektrische Keramik aufweist; und/oder
die Vibratorvorrichtung (200) ferner eine auf der Verklebungsfläche (213) angeordnete Kleberschicht aufweist, und die Kleberschicht dazu ausgebildet ist, die Verklebungsfläche (213) mit dem Körper (100) zu verbinden; und/oder
die Vibratorvorrichtung (200) ferner eine flexible Platine (220) aufweist, und die flexible Platine (220) mit den mehreren Vibratoren (210) auf einer der Verklebungsfläche (213) gegenüberliegenden Fläche verbunden ist.

5. Elektronische Vorrichtung nach einem der Ansprüche 1-4, ferner mit einem Controller, welcher mit der Vibratorvorrichtung (200) verbunden ist,
wobei der Controller dazu ausgebildet ist, die Vibration zweier oder mehr Vibratoren der mehreren Vibratoren (210) der Vibratorvorrichtung (200) zu steuern; und/oder
die Steuerung dazu ausgebildet ist, die mehreren Vibratoren (210) der Vibratorvorrichtung (200) zum Vibrieren unter mindestens einer treibenden Spannung zu steuern.

## Revendications

1. Dispositif électronique, comprenant :
un corps (100) ; et
un appareil vibrant (200) comprenant :
une pluralité de vibrateurs (210), dans lequel l'appareil vibrant (200) est fixé dans le corps (100) du dispositif électronique, la pluralité de vibrateurs (210) sont disposés séparément dans le corps (100) et configurés pour vibrer afin de générer un son, et chacun de la pluralité de vibrateurs (210) comprennent une face de collage (213) conçue pour être collée au corps (100),
dans lequel deux vibrateurs ou plus de la pluralité de vibrateurs (210) ont au moins l'une des qualités différentes suivantes : épaisseurs, surfaces de la face de collage (213), ou formes de la face de collage (213),
dans lequel la pluralité de vibrateurs (210) comprennent un premier vibrateur (211) et au moins deux seconds vibrateurs (212), le premier vibrateur (211) et les au moins deux seconds vibrateurs (212) sont disposés séparément, et une surface d'une face de liaison (213) du premier vibrateur (211) est plus grande qu'une surface d'une face de liaison (213) d'au moins un parmi les au moins deux seconds vibrateurs (212),
dans lequel l'épaisseur du premier vibrateur (211) est supérieure à l'épaisseur d'au moins un des deux seconds vibrateurs (212),
l'épaisseur de chacun des vibrateurs (210) est mesurée le long d'une direction perpendiculaire à la face de collage (213),
dans lequel le corps (100) comprend un boîtier (110), un écran d'affichage (120) disposé sur une face avant du boîtier (110), et un espace entre le boîtier (110) et l'écran d'affichage (120), dans lequel l'appareil vibrant (200) est monté dans l'espace,
dans lequel les au moins deux seconds vibrateurs (212) sont disposés symétriquement autour du centre de gravité du premier vibrateur (211),
dans lequel les au moins deux seconds vibrateurs (212) sont disposés de manière circulaire, et la pluralité de vibrateurs (210) de l'appareil vibrant (200) sont collés sur une face du boîtier (110) faisant face à l'écran d'affichage (120) et conçue pour faire vibrer le boîtier (110) afin de générer un son.

2. Dispositif électronique selon la revendication 1, dans lequel les au moins deux seconds vibrateurs (212) sont disposés plus près d'un bord ou d'un coin du corps (100) que ne l'est le premier vibrateur (211).

3. Dispositif électronique selon l'une quelconque des revendications 1 à 2, dans lequel la pluralité de vibrateurs (210) comprennent un vibrateur à structure monocouche et/ou un vibrateur à structure multicouche.

4. Dispositif électronique selon l'une quelconque des revendications 1 à 3, dans lequel la pluralité de vibrateurs (210) comprennent au moins un film piézoélectrique ou une céramique piézoélectrique ; et/ou,
l'appareil vibrant (200) comprend en outre une couche adhésive disposée sur la face de liaison (213), et la couche adhésive est conçue pour relier la face de liaison (213) au corps (100) ;
et/ou,
l'appareil vibrant (200) comprend en outre une carte de circuit imprimé flexible (220), et la carte de circuit imprimé flexible (220) est connectée à la pluralité de vibrateurs (210) sur une face opposée à la face de liaison (213).

5. Dispositif électronique selon l'une quelconque des revendications 1 à 4, comprenant en outre un dispositif de commande connecté à l'appareil vibrant (200),
dans lequel le dispositif de commande est configuré pour commander la vibration de deux ou plusieurs vibrateurs de la pluralité de vibrateurs (210) de l'appareil vibrant (200) ; et/ou le dispositif de commande est configuré pour commander la pluralité de vibrateurs (210) de l'appareil vibrant (200) afin qu'ils vibrent sous au moins une tension de commande.
